Europäisches Patentamt

European Patent Office

Office européen des brevets

(19)

(11) **EP 0 613 018 B1**

(12) **FASCICULE DE BREVET EUROPEEN**

(45) Date de publication et mention
de la délivrance du brevet:
**30.06.1999 Bulletin 1999/26**

(51) Int Cl.⁶: **G01R 31/02**, G01R 15/00,
G01R 27/18

(21) Numéro de dépôt: **94420048.4**

(22) Date de dépôt: **14.02.1994**

(54) **Dispositif de contrôle et de mesure d'isolement pour réseau électrique**

Vorrichtung zur Überwachung und Messung der Isolation eines Stromversorgungsnetzes

Device for monitoring and measuring the insulation of an electrical network

(84) Etats contractants désignés:
**DE ES GB IT**

(30) Priorité: **25.02.1993 FR 9302407**

(43) Date de publication de la demande:
**31.08.1994 Bulletin 1994/35**

(73) Titulaire: **SCHNEIDER ELECTRIC SA**
**92100 Boulogne Billancourt (FR)**

(72) Inventeurs:
• **Suptitz, Eric, Merlin Gérin**
**F-38050 Grenoble Cédex 09 (FR)**
• **Weynachter, Luc, Merlin Gérin**
**F-38050 Grenoble Cédex 09 (FR)**
• **Forveil, Roger, Merlin Gérin**
**F-38050 Grenoble Cédex 09 (FR)**
• **Allin, Patrice, Merlin Gérin**
**F-38050 Grenoble Cédex 09 (FR)**

(74) Mandataire: **Jouvray, Marie-Andrée et al**
**Schneider Electric SA,**
**Sce. Propriété Industrielle**
**38050 Grenoble Cédex 09 (FR)**

(56) Documents cités:
EP-A- 0 399 923          FR-A- 2 676 821
US-A- 4 857 830

EP 0 613 018 B1

**Description**

L'invention concerne un dispositif de contrôle et de mesure d'isolement pour réseau électrique comportant : des moyens d'injection dans le réseau d'un courant ou d'une tension d'injection de fréquence différente de la fréquence du réseau,

- au moins un capteur de courant entourant des conducteurs d'une portion de réseau à contrôler,
- des moyens de traitement comportant des moyens de mesure connectés à au moins une sortie du capteur de courant pour fournir un premier signal de sortie du capteur représentatif de courant de fuite,

Les dispositifs de mesure de l'isolement électrique comportent, de manière connue, des capteurs de courant. Les capteurs sont généralement des tores qui entourent l'ensemble des conducteurs d'un réseau ou d'une dérivation de réseau à contrôler. Dans les réseaux à neutre isolé un courant, ou une tension de mesure, de fréquence différente de celle du réseau, est injecté entre un conducteur du réseau et la terre ou la masse. Un tel dispositif est décrit dans le document FR-A-2.647.220.

La localisation d'un défaut d'isolement nécessite l'installation de contrôleurs locaux avec des tores de mesure répartis sur des parties du réseau ou sur des dérivations comme celui décrit dans le document FR-A-2.676.821. De manière connue des liaisons, entre un contrôleur principal et les contrôleurs locaux, transmettent des informations et un signal de synchronisation correspondant au courant ou à la tension d'injection. Ce signal de synchronisation permet une détection ou une démodulation synchrone des valeurs des courants de fuite, en séparant les composantes résistives et capacitives dudit courant.

Les tores de mesure transforment des courants, de fuite ou de défaut, primaires en courants secondaires mesurés par des résistances de mesure. Mais les tores ont des composantes inductive et résistive qui introduisent un déphasage et peuvent fausser les mesures par détection synchrone. Des dispositifs de correction permettent de tenir compte de la self et de la résistance des tores, par une mesure préalable et un réglage d'un déphasage compensateur. Dans certains contrôleurs, des dispositifs complexes font des mesures périodiques de ces composantes et ajustent la valeur du déphasage de compensation de manière à corriger les dérives de ces composantes, notamment en température.

Dans les dispositifs de correction connus, la mesure des composantes du tore se fait généralement en appliquant un signal calibré en entrée du tore et en mesurant les signaux de sortie par plusieurs points de mesure sur des impédances différentes et connues. Ces modes de correction nécessitent l'arrêt de l'injection du courant ou de la tension d'injection dans le réseau pendant la mesure des composantes du tore. Pour tenir compte de l'ensemble des caractéristiques du tore, le signal calibré peut être appliqué sur un enroulement supplémentaire du tore. Un tel dispositif est décrit dans le document US 4,857,830. Ceci a pour conséquence une augmentation de la complexité des dispositifs de correction et un nombre plus élevé de connexions entre les tores et les entrées des contrôleurs.

L'invention a pour but un dispositif de contrôle d'isolement comportant une correction des erreurs dues aux capteurs, sans interruption du courant ou de la tension d'injection pour l'évaluation des erreurs.

Selon l'invention, les moyens de traitement comportent :

- des moyens de production d'un signal de référence destiné à être injecté sur ladite sortie dudit capteur,
- des moyens de superposition connectés entre les moyens de production et la sortie dudit capteur pour superposer périodiquement, pendant un cycle d'étalonnage, le signal de référence au premier signal de sortie dudit capteur, les moyens de mesure fournissant pendant la superposition un second signal, et
- des moyens de correction pour corriger le premier signal de sortie du capteur fourni par les moyens de mesure en fonction de valeurs du second signal obtenues pendant un cycle d'étalonnage, lesdits moyens de correction comportant des moyens de calcul de la différence de tension entre les signaux de mesure obtenus pendant le cycle d'étalonnage et les signaux de mesure obtenus en dehors du cycle d'étalonnage.

Selon un mode de réalisation de l'invention, les moyens de mesure comportent une résistance de mesure connectée aux extrémités du capteur de courant, et que les moyens de production d'un signal de référence comportent un générateur de courant de référence connecté périodiquement à la résistance de mesure.

Dans un mode préférentiel de réalisation, le signal de référence est un courant alternatif, de fréquence égale à la fréquence du courant ou de la tension d'injection, synchronisé avec les moyens d'injection desdits courant ou tension d'injection de manière à avoir un déphasage nul ou connu.

Selon un mode particulier de réalisation, les moyens de correction comportent des moyens d'extraction des parties réelle et imaginaire de la différence de tension, et de calcul des paramètres de correction.

Selon un développement des modes de réalisation, les moyens d'extraction et de calcul comportent des moyens de calcul des composantes résistive (RT) et réactive (L) du capteur, et des moyens de calcul d'un paramètre de correction sous la forme (Rm + RT) / Lω, où Rm est la résistance des moyens de mesure et ω la pulsation du courant ou de la tension d'injection.

Selon un autre développement, les moyens d'extraction et de calcul comportent des moyens de calcul d'un paramètre de correction sous la forme : (Rm . I ref - v3r) / v3i, où Rm est la résistance des moyens de mesure et où v3r et v3i sont respectivement les parties réelle et imaginaire de la différence de tension.

Selon un développement d'un mode préférentiel de réalisation, les moyens de traitement comportent une résistance de mesure connectée aux extrémités du capteur, un filtre passe-bas ou passe-bande, connecté à la résistance de mesure, un dispositif de détection connecté à la sortie du filtre et à une ligne de synchronisation fournissant un signal de synchronisation synchronisée avec le courant ou la tension d'injection, le dispositif de détection fournissant une partie réelle et une partie imaginaire des signaux de mesure, les moyens de production du courant de référence étant synchronisés avec le signal de synchronisation.

D'autres avantages et caractéristiques ressortiront plus clairement de la description qui va suivre, de modes particuliers de réalisation de l'invention, donnés à titre d'exemples non limitatifs, et représentés aux dessins annexés sur lesquels:

La figure 1 représente le schéma d'un dispositif comportant un contrôleur central et des contrôleurs locaux dans lequel l'invention peut être mise en oeuvre.

La figure 2 montre la connexion, selon l'art antérieur, d'un tore sur une résistance de mesure d'un contrôleur local selon la figure 1.

La figure 3 montre une modélisation d'un tore connecté selon la figure 2.

La figure 4 montre la modélisation d'un tore, auquel un générateur de courant est connecté pendant un cycle d'étalonnage.

La figure 5 montre un schéma bloc d'un dispositif de mesure comportant le mode de réalisation de la figure 4.

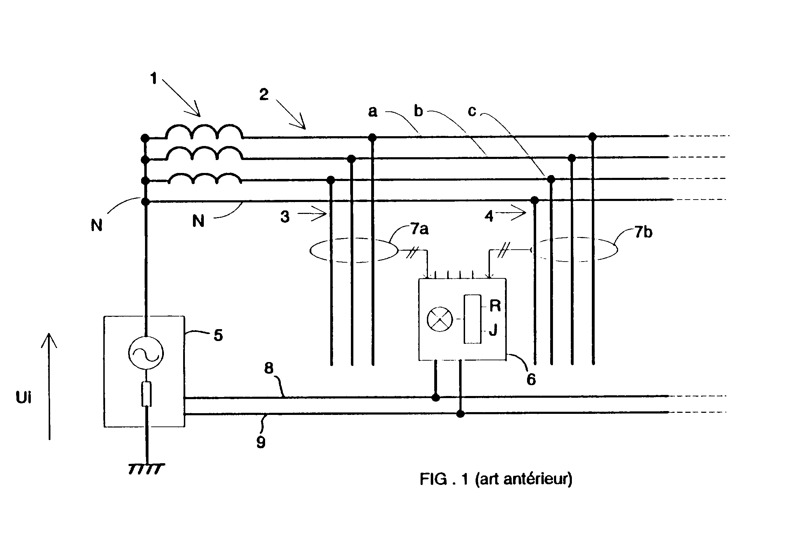

Un réseau de distribution représenté à la figure 1 comporte un dispositif de contrôle et de mesure de l'isolement. Le branchement du réseau est du type à neutre isolé. Un transformateur 1 a trois enroulements branchés en étoile. Une première extrémité de chaque enroulement est connectée à un conducteur commun neutre N, et une deuxième extrémité de chaque enroulement est connectée séparément à un des trois conducteurs a, b ou c de phase d'une ligne de distribution 2. Sur la ligne de distribution 2, comportant les 3 conducteurs de phase a, b, c, et éventuellement de neutre N, il peut y avoir des dérivations 3 ou 4 pour l'alimentation de départs vers d'autres circuits.

Un contrôleur d'isolement principal 5 injecte entre un conducteur du réseau, par exemple le neutre N, et la terre, une tension, ou un courant, d'injection Ui de fréquence différente de la fréquence du réseau. Ensuite, il mesure les composantes résistive et capacitive du réseau de manière à détecter un défaut d'isolement. Cette mesure est globale pour l'ensemble du réseau et ne permet pas de localiser le défaut.

Des contrôleurs locaux 6 permettent de localiser les défauts. Ils comportent des entrées sur lesquelles sont connectées des sorties de capteurs, par exemple des enroulements secondaires de tores 7a, 7b de mesure. Un tore de mesure entoure l'ensemble des conducteurs d'une dérivation à contrôler, généralement les trois conducteurs de phase comme dans la dérivation 3 auxquels peut s'ajouter le conducteur de neutre comme dans la dérivation 4. Les contrôleurs locaux mesurent et séparent les composantes réelle et imaginaire de la somme des courants traversant les tores. Les composantes réelles de ces courants sont représentatives de la valeur d'un défaut d'isolement et les composantes imaginaires sont représentatives d'un couplage capacitif entre les lignes du réseau et la terre. Les valeurs des composantes réelles et imaginaires sont extraites à l'aide d'une détection synchrone en phase avec la tension injectée par le contrôleur principal 5. Cette synchronisation est assurée par une ligne 8 de synchronisation portant un signal représentatif de la phase de la tension injectée Ui.

Une ligne 9 de données permet les échanges d'informations entre le contrôleur principal et les contrôleurs locaux. Les informations transmises sont notamment les valeurs des composantes des courants de fuite traversant le tore. Chaque contrôleur local peut recevoir la connexion d'un ou plusieurs tores de mesure. Les lignes de synchronisation et de données peuvent être connectées à un ou plusieurs contrôleurs locaux.

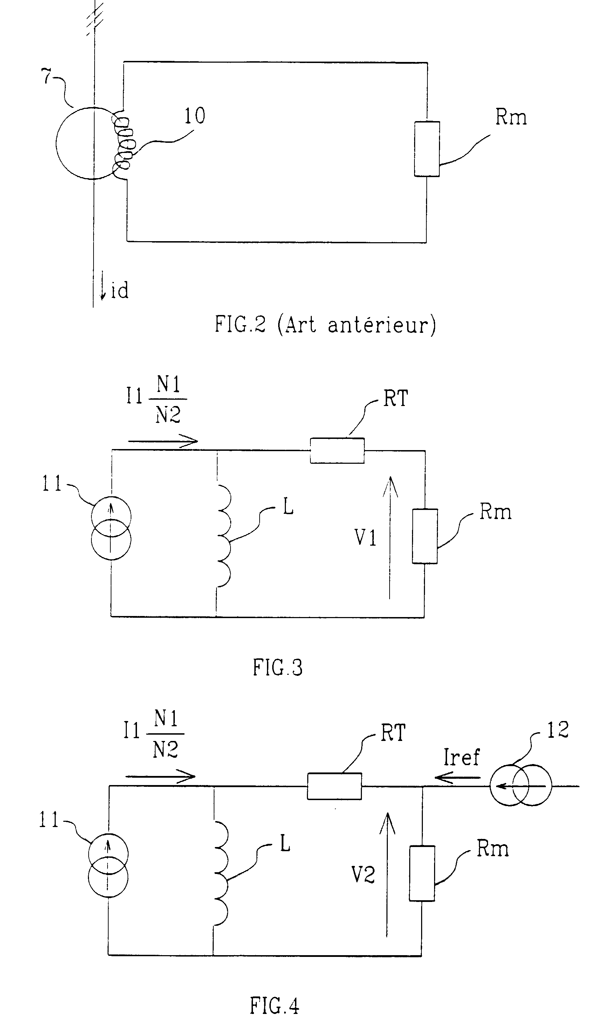

Le mode de branchement d'un tore sur un contrôleur local selon l'art antérieur est représenté à la figure 2. Un tore 7 entoure tous les fils de la dérivation à contrôler. Un enroulement secondaire 10 est connecté à une résistance Rm de mesure du contrôleur local. Le courant id primaire traversant le tore correspond à la somme vectorielle de tous les courants des conducteurs. n est représentatif des courants de fuite, de mode commun ou de couplage capacitif. Le courant id comporte une composante réelle ir et une composante imaginaire ii, soit selon la notation usuelle : id = ir + jii, ou j correspond à la notation de la partie imaginaire.

Une modélisation du tore 7 avec ses composantes inductive et résistive est représenté à la figure 3. Le tore est représenté par un générateur de courant 11 fournissant un courant I1 (N1/N2), où I1 est le module du courant primaire, N1 le nombre de spires de l'enroulement primaire et N2 le nombre de spires de l'enroulement secondaire. Une self L, représentative de la composante inductive du tore, est connectée en parallèle sur le générateur de courant 11. Une résistance RT, représentative de la composante résistive du tore, est connectée en série avec la résistance de mesure Rm aux bornes du générateur 11. Une première tension V1 mesurée aux bornes de la résistance de mesure Rm dépend des valeurs de L et RT. Son expression est donnée par :

$$V1 = I1\,(N1/N2)\,.\,(Rm\,.jL\omega)\,/\,(Rm + RT + jL\omega) \tag{1}$$

où $\omega$ est la pulsation correspondant à la fréquence de la tension injectée Ui.

Sur la figure 4, un générateur de courant 12 est connecté périodiquement pendant un cycle d'étalonnage, à une extrémité de la résistance de mesure Rm. Le générateur 12 permet de superposer un courant Iref de référence et de mesurer une deuxième valeur de tension V2 aux bornes de la résistance de mesure Rm. L'expression de V2 est :

$$V2 = (I1\,(N1/N2)\,Rm\,.jL\omega)\,/\,(Rm + RT + jL\omega\,) + (Iref\,.\,Rm\,(jL\omega + RT))\,/\,(Rm + RT + jL\omega\,) \tag{2}$$

Une troisième valeur de tension V3, représentative de la différence entre la deuxième et la première valeur de la tension de mesure aux bornes de la résistance Rm.
L'expression de V3 est :

$$V3 = V2 - V1 = ((RT + jL\omega).\,(Rm\,.\,Iref))\,/\,(Rm + RT + jL\omega) \tag{3}$$

V3 peut être décomposé en une composante réelle v3r et une composante imaginaire v3i,

$$V3 = v3r + j\,v3i \tag{4}$$

Le courant de référence a la même fréquence que le courant ou la tension d'injection et est synchronisé sur celui-ci de manière à avoir un déphasage nul ou connu.

Une identification des parties réelle et imaginaire permet d'obtenir les valeurs de la composante résistive RT et de la composante inductive L et d'obtenir la valeur corrigée de I1 à partir de l'équation (1).

Les valeurs V2 et V3 sont obtenues périodiquement pendant des cycles d'étalonnage et permettent de recalculer les valeurs de L et de RT.

On peut montrer que I1 peut s'exprimer sous la forme :

$$i1r\,(N1/N2)\,.\,Rm = v1r + tg\,\varphi\,.\,v1i \tag{5}$$

$$i1i\,(N1/N2)\,.\,Rm = v1i - tg\,\varphi\,.\,v1r \tag{6}$$

où i1r et i1i sont respectivement les composantes réelle et imaginaire de I1. La valeur tg $\varphi$ est calculée à chaque cycle d'étalonnage.
Selon une première variante, tg $\varphi$ est obtenu par l'équation

$$tg\,\varphi = (Rm + Rl)\,/\,L\omega \tag{7}$$

Selon une seconde variante :

$$tg\,\varphi = (Rm\,Iref - v3r)\,/\,v3i \tag{8}$$

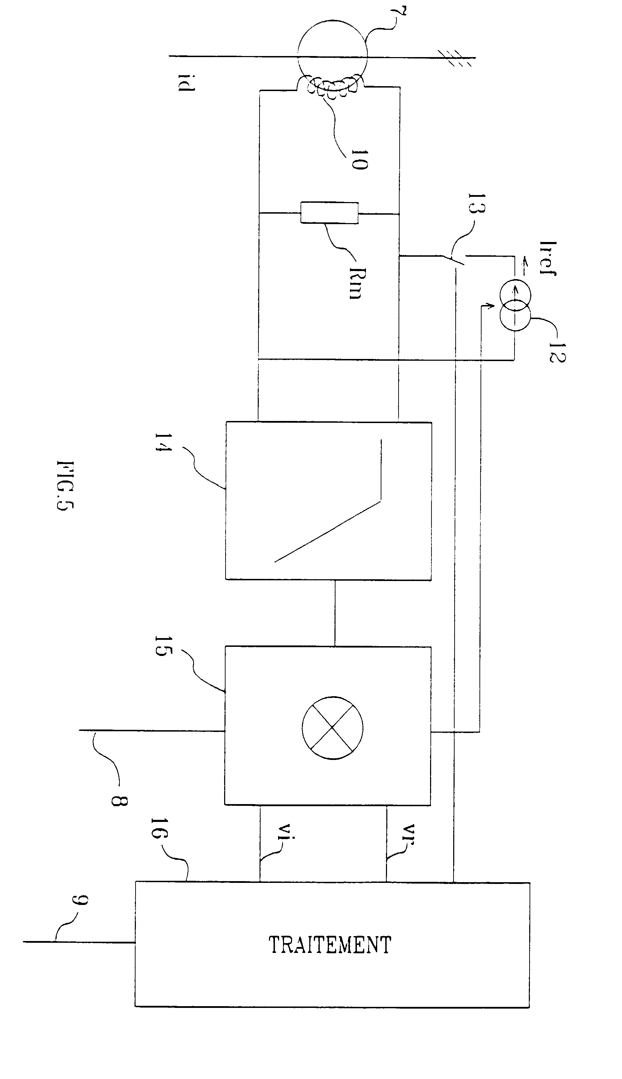

Un dispositif comportant une correction selon un mode de réalisation préférentiel de l'invention est représenté à la figure 5. L'enroulement secondaire 10 du tore est connecté en parallèle sur la résistance Rm de mesure. Le générateur 12 de courant de référence est connecté à une extrémité de la résistance Rm à travers un interrupteur 13. La tension de mesure aux bornes de la résistance Rm est appliquée à l'entrée d'un filtre 14, passe-bas ou passe-bande, qui laisse passer les signaux de fréquence équivalente à la fréquence de la tension Ui injectée par le contrôleur principal. La sortie du filtre est appliquée à un détecteur synchrone 15 qui fournit en sortie les valeurs des parties réelles vr et des parties imaginaires vi de la tension mesurée aux bornes de la résistance de mesure Rm. Le détecteur 15 utilise les signaux de synchronisation transmis par la ligne 8. Ces signaux servent également à synchroniser le générateur 12 de courant de référence Iref. Un circuit 16 de traitement traite les valeurs mesurées, commande l'ouverture et la fermeture de l'interrupteur 13, calcule les composantes du tore et les paramètres de correction, et corrige les valeurs de V1 de manière à reconstituer des valeurs corrigées des composantes de I1. Ces valeurs de I1 peuvent être affichées ou transmises sur la ligne 9 vers le contrôleur principal ou vers un concentrateur de données.

Lorsque l'interrupteur 13 est ouvert, les valeurs mesurées vr et vi sont représentatives des valeurs v1r et v1i de mesure en l'absence de courant de référence. La fermeture de l'interrupteur 13, pendant un cycle d'étalonnage permet de mesurer des valeurs vr et vi représentatives des valeurs v2r et v2i de la tension de mesure lors de l'application d'un courant de référence Iref. Après l'acquisition de ces valeurs le circuit de traitement 16 calcule les valeurs v3r et v3i de la manière suivante : v3r = v2r - v1r et v3i = v2i - v1i. Lorsque les valeurs v3r et v3i ont été calculées, le circuit 16 détermine les paramètres de correction tg φ par l'équation (8). Il corrige ensuite les valeurs de I1 sur la base des équations (5) et (6).

Les opérations décrites ci-dessus correspondent à un cycle de mesure avec un cycle d'étalonnage. Le cycle d'étalonnage se produit périodiquement de manière à redéfinir les valeurs V3 et tg φ dépendant des composantes inductive et résistive du tore. Les valeurs des composantes du tore peuvent varier en fonction notamment de la température. En fonctionnement, hors cycle d'étalonnage, l'interrupteur 13 reste ouvert, les valeurs v1r et v1i sont mesurées, et les valeurs i1r et i1i sont évaluées en tenant compte des valeurs de v3r, v3i ou tg φ gardées dans une mémoire entre deux cycles d'étalonnage.

Le mode de réalisation selon la figure 5 comporte un tore, une résistance de mesure, un circuit de filtrage, un circuit de détection synchrone, un générateur de courant et un circuit de traitement. Dans le cas où un contrôleur d'isolement comporte plusieurs entrées pour la connexion des tores, une partie ou l'ensemble des éléments peut être commun à plusieurs tores. Un circuit de multiplexage serait, dans ce cas, nécessaire pour la mesure séquentielle des différents courants de mesure venant des tores.

Le circuit de traitement effectue les calculs, contrôle le cycle d'étalonnage, et communique des données par la ligne 9. Il peut également contrôler un affichage local des valeurs des courants mesurés ou produire une signalisation d'un défaut d'isolement lorsque le courant de fuite d'une ligne ou d'une dérivation dépasse une valeur prédéterminée.

Les capteurs de courant décrits ci-dessus sont des tores. L'invention peut également s'appliquer à des dispositifs comportant d'autres types de capteurs, notamment des transformateurs de courant dont le circuit magnétique n'est pas de forme torique, des capteurs de courant sans circuit magnétique, ou des capteurs avec cellule à effet hall.

Les composantes des capteurs génèrent des erreurs qui se manifestent par des composantes réactives et des composantes résistives. Les composantes réactives sont souvent inductives, mais l'invention peut également être utilisée lorsque les composantes réactives sont capacitives. Dans tous les cas, il sera possible de définir un modèle permettant d'exprimer la valeur corrigée de I1 en fonction des valeurs de V3.

Le paramètre de correction utilisé de manière préférentielle est représenté par une tangente, mais il est évident que d'autres valeurs peuvent être utilisées sans sortir du cadre de l'invention, dans des expressions différentes de la correction, notamment des cotangentes, sinus, cosinus ou autres fonctions qui ne sont pas obligatoirement circulaires.

**Revendications**

1.   Dispositif de contrôle et de mesure d'isolement pour réseau électrique comportant

-   des moyens d'injection dans le réseau d'un courant ou d'une tension (Ui) d'injection de fréquence différente de la fréquence du réseau,
-   au moins un capteur de courant (10) entourant des conducteurs d'une portion de réseau à contrôler,
-   des moyens de traitement (6) comportant des moyens (Rm) de mesure connectés à au moins une sortie du capteur de courant pour fournir un premier signal (V1) de sortie du capteur (10) représentatif de courant de fuite (I1),

dispositif caractérisé en ce que les moyens de traitement comportent :

-   des moyens (12) de production d'un signal de référence (Iref) destiné à être injecté sur ladite sortie dudit capteur,
-   des moyens (13) de superposition connectés entre les moyens de production et la sortie dudit capteur pour superposer périodiquement, pendant un cycle d'étalonnage, le signal de référence (Iref) au premier signal (V1) de sortie dudit capteur (10), les moyens de mesure fournissant pendant la superposition un second signal (V2), et

- des moyens de correction (16) pour corriger le premier signal de sortie (V1) du capteur fourni par les moyens de mesure en fonction de valeurs du second signal (V2) obtenues pendant un cycle d'étalonnage, lesdits moyens de correction comportant des moyens de calcul de la différence de tension (V3) entre les signaux de mesure (V2) obtenus pendant le cycle d'étalonnage et les signaux de mesure (V1) obtenus en dehors du cycle d'étalonnage.

2. Dispositif selon la revendication 1, caractérisé en ce que les moyens de mesure comportent une résistance de mesure (Rm) connectée aux extrémités (10) du capteur de courant, et que les moyens de production d'un signal de référence comportent un générateur (12) de courant (Iref) de référence connecté périodiquement à la résistance de mesure Rm.

3. Dispositif selon l'une des revendications 1 et 2, caractérisé en ce que le signal de référence (Iref) est un courant alternatif, de fréquence égale à la fréquence du courant ou de la tension d'injection (Ui), synchronisé avec les moyens d'injection desdits courant ou tension d'injection de manière à avoir un déphasage nul ou connu.

4. Dispositif selon l'une quelconque des revendications 1 à 3, caractérisé en ce que les moyens de correction comportent des moyens (16) d'extraction des parties réelle (V3r) et imaginaire (V3i) de la différence de tension (V3), et de calcul des paramètres de correction.

5. Dispositif selon la revendication 4, caractérisé en ce que les moyens (16) d'extraction et de calcul comportent des moyens de calcul des composantes résistive (RT) et réactive (L) du capteur, et des moyens de calcul d'un paramètre de correction sous la forme $(Rm + RT) L\omega$, où Rm est la résistance des moyens de mesure et la pulsation du courant ou de la tension d'injection.

6. Dispositif selon la revendication 4, caractérisé en ce que les moyens (16) d'extraction et de calcul comportent des moyens de calcul d'un paramètre de correction sous la forme : $(Rm . Iref - v3r) / v3i$, où Rm est la résistance des moyens de mesure et où v3r et v3i sont respectivement les parties réelle et imaginaire de la différence de tension (V3).

7. Dispositif selon l'une quelconque des revendications 1 à 6, caractérisé en ce que les moyens de traitement comportent une résistance de mesure (Rm) connectée aux extrémités du capteur, un filtre (14) passe-bas ou passe-bande, connecté à la résistance de mesure, un dispositif de détection (15) connecté à la sortie du filtre et à une ligne de synchronisation (8) fournissant un signal de synchronisation synchronisée avec le courant ou la tension d'injection, le dispositif de détection fournissant une partie réelle (vr) et une partie imaginaire (vi) des signaux de mesure, les moyens (12) de production du courant de référence étant synchronisés avec le signal de synchronisation.

**Patentansprüche**

1. Isolationsüberwachungs- und -meßeinrichtung für elektrische Leitungsnetze mit

   - Mitteln zur Einleitung eines Prüfstroms oder einer Prüfspannung (Ui) mit einer von der Netzfrequenz abweichenden Frequenz in das Netz,
   - mindestens einem, um die Leiter (10) eines zu überwachenden Netzabschnitts geführten Stromwandler,
   - Verarbeitungsmitteln (6) mit Meßmitteln (Rm), die an mindestens einen Ausgang des Stromwandlers angeschlossen sind, um ein erstes, einen Leckstrom (I1) abbildendes Ausgangssignal (V1) des Stromwandlers (10) zu liefern,

   welche Einrichtung dadurch gekennzeichnet ist, daß die Verarbeitungsmittel

   - Mittel (12) zur Erzeugung eines Referenzsignals (Iref), das dazu dient, den genannten Ausgang des genannten Stromwandlers zu beaufschlagen,
   - zwischen die Signalerzeugungsmittel und den Ausgang des genannten Stromwandlers geschaltete Überlagerungsmittel (13), die dazu dienen, im Verlauf eines Kalibrierzyklus' das erste Ausgangssignal (V1) des genannten Stromwandlers (10) mit dem Referenzsignal (Iref) zu überlagern, wobei die Meßmittel während der Überlagerung ein zweites Signal (V2) liefern, sowie
   - Korrekturmittel (16) zur Korrektur des von den Meßmitteln gelieferten ersten Ausgangssignals (V1) des Stromwandlers in Abhängigkeit von während eines Kalibrierzyklus' erfaßten Werten des zweiten Signals (V2) umfassen, wobei die genannten Korrekturmittel Mittel zur Berechnung der Spannungsdifferenz (V3) zwischen den während des Kalibrierzyklus' erfaßten Meßsignalen (V2) und den außerhalb des Kalibrierzyklus' erfaßten Meßsignalen (V1) umfaßt.

2. Einrichtung nach Anspruch 1, dadurch gekennzeichnet, daß die Meßmittel einen an die Anschlüsse (10) des Stromwandlers angeschlossenen Meßwiderstand (Rm) und die Mittel zur Erzeugung eines Referenzsignals eine periodisch mit dem Meßwiderstand (Rm) verbundene Stromquelle (12) zur Lieferung eines Referenzstroms (Iref) umfassen.

3. Einrichtung nach Anspruch 1 oder 2, dadurch gekennzeichnet, daß das Referenzsignal (Iref) ein Wechselstrom ist, der die gleiche Frequenz aufweist wie der Prüfstrom bzw. die Prüfspannung (Ui) und der mit den Mitteln zur Einspeisung des genannten Prüfstroms bzw. der genannten Prüfspannung synchronisiert ist, derart daß sich eine Phasenverschiebung von null oder mit einem bekannten Wert ergibt.

4. Einrichtung nach irgendeinem der Ansprüche 1 bis 3, dadurch gekennzeichnet, daß die Korrekturmittel Mittel (16) zur Bestimmung des Realanteils (V3r) und des Imaginäranteils (V3i) der Spannungsdifferenz (V3) sowie zur Berechnung der Korrekturparameter umfassen.

5. Einrichtung nach Anspruch 4, dadurch gekennzeichnet, daß die Bestimmungs- und Berechnungsmittel (16) Mittel zur Berechnung des Wirkanteils (RT) und des Blindanteils (L) des Stromwandlers sowie Mittel zur Berechnung eines Korrekturparameters in Form des Ausdrucks (Rm + RT) / Lω umfassen, wobei Rm den Widerstand der Meßmittel und ω die Winkelgeschwindigkeit des Prüfstroms bzw. der Prüfspannung darstellen.

6. Einrichtung nach Anspruch 4, dadurch gekennzeichnet, daß die Bestimmungs- und Berechnungsmittel (16) Mittel zur Berechnung eines Korrekturparameters in Form des Ausdrucks (Rm . Iref - v3r) / v3i umfassen, wobei Rm den Widerstand der Meßmittel sowie v3r und v3i den Realanteil bzw. Imaginäranteil der Spannungsdifferenz (V3) darstellen.

7. Einrichtung nach irgendeinem der Ansprüche 1 bis 6, dadurch gekennzeichnet, daß die Verarbeitungsmittel einen an die Anschlüsse des Stromwandlers angeschlossenen Meßwiderstand (Rm), ein an den Meßwiderstand angeschlossenes Tiefpaß- oder Bandpaßfilter (14) sowie ein Erfassungsglied (15) umfassen, das an den Ausgang des Filters sowie an eine Synchronisationsleitung (8) angeschlossen ist, die ein mit dem Prüfstrom bzw. der Prüfspannung synchronisiertes Synchronisationssignal liefert, wobei das Erfassungsglied einen Realanteil (vr) und einen Imaginäranteil (vi) der Meßsignale liefert und die Mittel (12) zur Erzeugung des Referenzstroms mit dem Synchronisationssignal synchronisiert sind.

## Claims

1. An isolation monitoring and measuring device for an electrical power system comprising:

    - means for input to the power system of an input current or voltage (Ui) of a different frequency from the power system frequency,
    - at least one current sensor (10) surrounding the conductors of a portion of power system to be monitored,
    - processing means (6) comprising measuring means (Rm) connected to at least one output of the current sensor to supply a first output signal (V1) of the sensor (10) representative of leakage current (I1),

    a device characterized in that the processing means comprise :

    - means (12) for producing a reference signal (Iref) designed to be input on said output of said sensor,
    - superpositioning means (13) connected between the means for producing a reference signal and the output of said sensor to periodically superpose, during a calibration cycle, the reference signal (Iref) on the first output signal (V1) of said sensor (10), the measuring means supplying a second signal (V2) during superposition, and
    - correction means (16) to correct the first output signal (V1) of the sensor supplied by the measuring means according to values of the second signal (V2) obtained during a calibration cycle, said correction means comprising means for calculating the voltage difference (V3) between the measuring signals (V2) obtained during the calibration cycle and the measuring signals (V1) obtained outside the calibration cycle.

**2.** The device according to claim 1, characterized in that the measuring means comprise a measuring resistance (Rm) connected to the ends (10) of the current sensor, and that the means for producing a reference signal comprise a generator (12) of a reference current (Iref) periodically connected to the measuring resistance (Rm).

**3.** The device according to one of the claims 1 and 2, characterized in that the reference signal (Iref) is an alternating current, of frequency equal to the frequency of the input current or voltage (Ui), synchronized with the input means of said input current or voltage so as to have a zero or known phase difference.

**4.** The device according to any one of the claims 1 to 3, characterized in that the correction means comprise means (16) for extracting the real (V3r) and imaginary (V3i) parts of the voltage difference (V3), and of calculating the correction parameters.

**5.** The device according to claim 4, characterized in that the means (16) for extracting and calculating comprise means for calculating the resistive (RT) and reactive (L) components of the sensor, and means for calculating a correction parameter in the form (Rm + RT) Lω, where Rm is the resistance of the measuring means and ω the pulse of the input current or voltage.

**6.** The device according to claim 4, characterized in that the means (16) for extracting and calculating comprise means for calculating a correction parameter in the form : (Rm . Iref - v3r) / v3i, where Rm is the resistance of the measuring means and where v3r and v3i are respectively the real and imaginary parts of the voltage difference (V3).

**7.** The device according to any one of the claims 1 to 6, characterized in that the processing means comprise a measuring resistance (Rm) connected to the ends of the sensor, a low-pass or band-pass filter (14) connected to the measuring resistance, a detection device (15) connected to the output of the filter and a synchronization line (8) supplying a synchronization signal synchronized with the input current or voltage, the detection device supplying a real part (vr) and an imaginary part (vi) of the measuring signals, the means (12) for producing the reference current being synchronized with the synchronization signal.

FIG . 1 (art antérieur)

FIG.2 (Art antérieur)

$I1 \dfrac{N1}{N2}$

FIG.3

$I1 \dfrac{N1}{N2}$

FIG.4

FIG.5